# EUROPEAN PATENT APPLICATION

(11) **EP 4 716 019 A1**
(43) Date of publication of application: **25.03.2026**
(21) Application number: 24838779.7
(22) Date of filing: 08.07.2024
(51) Int. Cl.: H01R 13/02, H01R 13/52, H01R 13/24, H05K 5/02, H05K 5/06

(54) **ELECTRONIC DEVICE**

(30) Priority: 11.07.2023 CN 202310851318
(71) Applicant: Honor Device Co., Ltd., Shenzhen, Guangdong 518040 (CN)
(72) Inventor: SUN, Lianyi, Shenzhen, Guangdong 518040 (CN); BI, Lingyu, Shenzhen, Guangdong 518040 (CN); JIANG, Cheng, Shenzhen, Guangdong 518040 (CN); SUN, Gaolong, Shenzhen, Guangdong 518040 (CN)
(74) Representative: Thun, Clemens
(86) International application number: PCT/CN2024/104272
(87) International publication number: WO 2025/011526

(57) **Abstract**

This application provides an electronic device, which relates to the technical field of electronic products, and can prevent corrosion at an electrical conduction portion between components. The electronic device includes a first component, a second component, a conductive member, and a sealing ring. The conductive member is arranged between the first component and the second component, and is in electrical conduction with the first component and the second component. The sealing ring is arranged between the first component and the second component, one end of the sealing ring in an axial direction faces the first component, and the other end of the sealing ring faces the second component. The conductive member is located within a region surrounded by the sealing ring.

## Description

This application claims priority to Chinese Patent Application No. 202310851318.X, filed with the China National Intellectual Property Administration on July 11, 2023 and entitled "ELECTRONIC DEVICE", which is incorporated herein by reference in its entirety.

### TECHNICAL FIELD

This application relates to the technical field of electronic products, and in particular, to an electronic device.

### BACKGROUND

In electronic devices such as mobile phones, tablet computers, and notebook computers, there is a requirement for electrical conduction between components, for example, electrical conduction between a hinge mechanism and a middle frame, or electrical conduction between a camera module and the middle frame. While meeting the requirement for electrical conduction, the components also need to prevent corrosion at an electrical conduction portion, to reduce impedance and passive inter-modulation (passive inter-modulation, PIM) characteristics. However, the related art often fails to meet this requirement.

### SUMMARY

This application provides an electronic device, which can prevent corrosion at an electrical conduction portion between components.

To achieve the foregoing objective, this application provides an electronic device. The electronic device includes a first component, a second component, a conductive member, and a sealing ring. The conductive member is arranged between the first component and the second component, and is in electrical conduction with the first component and the second component. The sealing ring is arranged between the first component and the second component, one end of the sealing ring in an axial direction faces the first component, and the other end of the sealing ring faces the second component. The conductive member is located within a region surrounded by the sealing ring.

In this way, the conductive member can help implement electrical conduction between the first component and the second component, and the sealing ring can help seal an electrical conduction portion between the first component and the second component can be sealed, preventing moisture ingress and preventing corrosion, thereby ensuring the reliability of the electrical connection. This enables the first component or the second component to be made of metals with active chemical properties, such as magnesium alloy, thereby expanding the material selection range for the first component and the second component, and helping reduce the weight of the electronic device.

The conductive member includes, but is not limited to, a conductive boss, a conductive gasket, a conductive elastic piece, and a conductive spring.

In a possible implementation, the conductive member is a conductive elastic piece. The conductive elastic piece has a small volume, which facilitates the installation between the first component and the second component with limited space.

In a possible implementation, the conductive elastic piece includes a fixed portion, an elastic arm portion, and a contact portion. The fixed portion is fixed to and in electrical conduction with the first component, and the contact portion is in contact with and in electrical conduction with the second component. A surface of the first component that faces the second component is a first surface. The elastic arm portion includes a first end portion and a second end portion that are opposite to each other, and is inclined relative to the first surface in a direction from the first end portion to the second end portion. The first end portion is connected to and in electrical conduction with the fixed portion. The second end portion is connected to and in electrical conduction with the contact portion. In this way, during an installation process of the conductive elastic piece between the first component and the second component, the elastic arm portion can undergo a bending deformation toward the first component, thereby storing an elastic force. This elastic force enables the contact portion to maintain stable contact against the second component, thereby ensuring the contact reliability between the contact portion and the second component. In addition, the conductive elastic piece can also adapt for installation between different gaps, and the conductive elastic piece has a small thickness, and can be installed in gaps with limited height without affecting the thickness of the electronic device, which is beneficial to the thinning of the electronic device.

In a possible implementation, the fixed portion includes a third end portion and a fourth end portion that are opposite to each other, and a direction from the third end portion to the fourth end portion is a first direction. The first direction is parallel to the first surface. The first end portion is connected to and in electrical conduction with the fourth end portion. An orthographic projection of the first end portion on the first surface is a first projection, an orthographic projection of the second end portion on the first surface is a second projection, and a direction from the first projection to the second projection is a second direction, where the second direction is opposite to the first direction. In this way, along a path of the third end portion → the fourth end portion → the first end portion → the second end portion, the conductive elastic piece undergoes at least one reverse bending. This can reduce the size of the conductive elastic piece in the first direction, preventing the first component and the second component from being designed with excessively large sizes in the first direction, thereby helping reduce the size of the electronic device.

In a possible implementation, the fixed portion and the elastic arm portion are arranged spaced apart along a third direction. The third direction is parallel to the first surface, and the third direction is perpendicular to the first direction. In this way, an orthographic projection region of the fixed portion on the first surface does not overlap with an orthographic projection region of the elastic arm portion on the first surface. This can prevent thickness stacking between the fixed portion and the elastic arm portion, thereby helping reduce the height of the conductive elastic piece. Therefore, it can reduce the stack thickness of the first component, the conductive elastic piece, and the second component, which is beneficial to the thinning of the electronic device.

In a possible implementation, the conductive elastic piece further includes a connecting portion. The connecting portion is located between the fourth end portion and the first end portion, and the connecting portion is connected to and in electrical conduction with both the fourth end portion and the first end portion. The connecting portion extends along the third direction from the fourth end portion to the first end portion. In this way, the fourth end portion and the first end portion are aligned in the third direction, thereby further reducing the size of the conductive elastic piece in the first direction.

In a possible implementation, an orthographic projection of the elastic arm portion on the first surface is a third projection, and a length of the third projection in the first direction is less than a length of the fixed portion in the first direction. In this way, since the contact portion is connected to the second end portion, under the premise that the fourth end portion and the first end portion are aligned in the third direction, the contact portion is located at a middle position of the conductive elastic piece in the first direction. A region surrounded by the sealing ring on the second surface is defined as a first region, so that the contact portion can be brought into contact with the first region at the middle position in the first direction, thereby further ensuring the reliability of the electrical connection.

In a possible implementation, an edge of the second end portion that is away from the first end portion is a first edge, and a portion of the second end portion on which the first edge is located forms the contact portion. In this way, the conductive elastic piece is simple in structure and is easy to manufacture.

In a possible implementation, an edge of the second end portion that faces the fixed portion is a second edge, and the second edge is a flange protruding toward the fixed portion. An edge of the second end portion that is away from the fixed portion is a third edge, and an arc transition edge or an inclined transition edge is connected between the third edge and the first edge.

When the arc transition edge is connected between the third edge and the first edge, the arc transition edge protrudes toward a direction away from the fixed portion, and the arc transition edge is tangent to both the first edge and the third edge. When the inclined transition edge is connected between the third edge and the first edge, one end of the inclined transition edge is connected to the third edge, the other end of the inclined transition edge extends in a direction away from the first end portion and is inclined to the fixed portion, and the other end is connected to the first edge.

In this way, in the third direction, the contact portion is closer to the fixed portion, that is, the contact portion is located at a middle position of the conductive elastic piece in the third direction, so that the contact portion can be brought into contact with the first region at the middle position in the third direction, thereby helping ensure the stability and reliability of the electrical connection.

In a possible implementation, an edge of the fixed portion that faces the elastic arm portion is provided with a first clearance notch. When the elastic arm portion bends toward the first component to be coplanar with the fixed portion, the first clearance notch is opposite to the second edge along the third direction. In this way, the first clearance notch can help create clearance for the portion of the second end portion at the second edge, preventing thickness stacking between the elastic arm portion and the fixed portion when the elastic arm portion bends to be coplanar with the fixed portion, thereby helping further reduce the thickness of the conductive elastic piece. In addition, the first clearance notch can help create clearance for the elastic arm portion, thereby reducing the distance between the elastic arm portion and the fixed portion in the third direction, and decreasing the size of the conductive elastic piece in the third direction.

In a possible implementation, the elastic arm portion further includes an intermediate section, and the intermediate section is connected between the first end portion and the second end portion. An edge of the intermediate section that faces the fixed portion is a fourth edge, and an edge of the connecting portion that faces a gap between the intermediate section and the fixed portion is a fifth edge. The fourth edge is connected to the fifth edge, and the fourth edge is inclined to the fixed portion along a direction from the second end portion to the first end portion. In this way, the width of the junction between the first end portion and the intermediate section is large, and the elastic arm portion has high structural strength and a large elastic force, enabling reliable contact between the contact portion and the second component.

In a possible implementation, an edge of the fixed portion that faces the elastic arm portion is provided with a second clearance notch. When the elastic arm portion bends toward the first component to be coplanar with the fixed portion, the second clearance notch is opposite to the fourth edge along the third direction. In this way, the second clearance notch can help create clearance for the portion of the intermediate section at the fourth edge, preventing thickness stacking between the elastic arm portion and the fixed portion when the elastic arm portion bends to be coplanar with the fixed portion, thereby helping further reduce the thickness of the conductive elastic piece. In addition, the second clearance notch can help create clearance for the portion of the intermediate section at the fourth edge, thereby reducing the distance between the elastic arm portion and the fixed portion in the third direction, and decreasing the size of the conductive elastic piece in the third direction.

In a possible implementation, the contact portion includes a contact portion main body and a first contact layer. The second end portion is connected to and in electrical conduction with the contact portion main body. The first contact layer is arranged on a surface of the contact portion main body, and an electrical conductivity of the first contact layer is higher than that of the contact portion main body. The first contact layer is in contact with the second component. In this way, the first contact layer can help improve the conductive efficiency between the contact portion main body and the second component, and reduce impedance and passive inter-modulation characteristics.

In a possible implementation, a material of the first contact layer includes at least one of gold, nickel, silver, or copper.

In a possible implementation, a surface of the first component that faces the second component is a first surface, and a surface of the second component that faces the first component is a second surface. The sealing ring is arranged between the first surface and the second surface. This does not affect the structural strength of the first component and the second component.

In a possible implementation, the first surface is provided with a first recessed groove, and the at least the fixed portion of the conductive elastic piece is accommodated within the first recessed groove. In this way, under the premise of a fixed height of a gap between the first component and the second component, the height of the conductive elastic piece can be increased to improve the structural strength and elasticity of the conductive elastic piece.

In a possible implementation, the second component includes a component body and a contact member. The contact member is fixed to and in electrical conduction with the component body, and the contact portion is in contact with the contact member. In this way, the second component is assembled by the component body and the contact member. The component body and the contact member can be made of different materials. For example, the component body can be made of a material with high structural strength and low costs (such as a steel material), and the contact member can be made of a material with an electrical conductivity higher than the component body, thereby balancing manufacturing costs and conductive efficiency.

In a possible implementation, a surface of the component body that faces the first component is provided with a second recessed groove, and the contact member is accommodated within the second recessed groove. In this way, the contact member is recessed within the component body, preventing thickness stacking between the component body and the contact member, which is beneficial to the thinning of the electronic device. In addition, the contact member not only can be in contact with a bottom surface of the second recessed groove, but also can be brought into contact with a side surface of the second recessed groove. Therefore, the contact area between the contact member and the component body is large, which can improve the conductive efficiency between the contact member and the component body.

In a possible implementation, the contact member includes a contact member body and a second contact layer. The second contact layer is at least arranged on a surface of the contact member body that faces the first component, and an electrical conductivity of the second contact layer is higher than that of the contact member body. The second end portion is in contact with and in electrical conduction with the second contact layer. In this way, the second contact layer can help improve the conductive efficiency between the contact portion main body and the second component, and reduce the impedance and the passive inter-modulation characteristics.

In a possible implementation, the electronic device further includes at least one fixing member, and the at least one fixing member is connected between the first component and the second component. The at least one fixing member is located on a side of the sealing ring that faces away from the conductive member. In this way, the conductive member and the sealing ring are not limited by the position of the fixing member, and the conductive member and the sealing ring can be arranged at positions with sufficient space, thereby avoiding an impact on the size of the second component and the connection stability between the first component and the second component.

In a possible implementation, the fixing member is a screw. The connection stability and reliability of the screw are good. In addition, a threaded surface of the screw can be provided with an insulating coating, and the insulating coating can prevent the first component and the second component from being electrically connected through the screw.

In a possible implementation, the first component is provided with a threaded hole, the second component is provided with a first through hole, and the first through hole is aligned with the threaded hole. An insulating material is arranged between the first component and the second component, the insulating material is provided with a clearance hole, and the clearance hole is aligned with and in communication with the through hole and the threaded hole. The screw includes a head and a shank, the head is located on a side of the second component that faces away from the first component, and the shank is accommodated within the first through hole, the clearance hole, and the threaded hole. In this way, the insulating material can help avoid direct contact between the second component and the first component at the position of the fixing member, thereby preventing corrosion.

In a possible implementation, a boss is provided between the first component and the second component, the boss is connected to one of the first component and the second component, and the insulating material is arranged between the other of the first component and the second component and the boss. A second through hole is provided within the boss, the second through hole is aligned with and in communication with the first through hole, the clearance hole, and the threaded hole, and the shank is accommodated within the first through hole, the second through hole, the clearance hole, and the threaded hole. In this way, the boss can help increase the height of the gap between the first component and the second component, preventing another region of the first surface from coming into contact with another region of the second surface, thereby reducing a corrosion risk. In addition, the boss can help prevent the flatness of the first surface and the second surface from affecting the connection reliability between the first component and the second component.

In a possible implementation, there are a plurality of fixing members, and the plurality of fixing members are connected between the edge of the second component and the first component. The conductive member and the sealing ring are located on a side of a plurality of fixed portions that faces a center of the second component. In this way, the spacing between the plurality of fixing members is large, and when the hinge mechanism rotates, the resistance arm of the plurality of fixing members is large, resulting in a large resistance torque. This can effectively prevent the separation of the second component from the first component, thereby ensuring the connection stability between the second component and the first component. In addition, since the conductive member and the sealing ring are located on the side of the plurality of fixed portions that faces the center of the second component, it can prevent the conductive member and the sealing ring from affecting the size of the second component and the connection stability between the first component and the second component.

In a possible implementation, a material of at least one of the first component or the second component is magnesium alloy. Magnesium alloy has low density, and good structural strength and rigidity, thereby helping reduce the weight of the electronic device and ensuring the structural strength and service life of the electronic device.

In a possible implementation, the electronic device includes a first middle frame and a hinge mechanism. The hinge mechanism includes a base, a first swing arm, and a first connector. The first swing arm may be rotatably connected to the base, the first connector is connected to an end of the first swing arm that is away from the base, and the first connector is fixed to the first middle frame. The first middle frame forms the first component, and the first connector forms the second component. Alternatively, the first middle frame forms the second component, and the first connector forms the first component. In this way, the electronic device is a foldable-screen device, and the weight of the foldable-screen device can be reduced.

### BRIEF DESCRIPTION OF DRAWINGS

FIG. 1 is a three-dimensional view of an electronic device according to some embodiments of this application in an unfolded state;
FIG. 2 is a schematic partial exploded view of the electronic device shown in FIG. 1;
FIG. 3 is a schematic diagram of a structure of the electronic device shown in FIG. 1 in a folded state;
FIG. 4 is a schematic diagram of a back surface structure of a first middle frame, a second middle frame, and a hinge mechanism in the electronic device shown in FIG. 1 and FIG. 2;
FIG. 5 is a schematic diagram of a cross-sectional structure of an assembly structure shown in FIG. 4 along a direction A-A;
FIG. 6 is a schematic diagram of a partial structure of an electronic device according to some embodiments of this application;
FIG. 7 is a partial enlarged view of a region I of the electronic device shown in FIG. 6;
FIG. 8 is a schematic diagram of a cross-sectional structure of the electronic device shown in FIG. 7 along a direction B-B;
FIG. 9 is a top view of a conductive member and a sealing ring in the electronic device shown in FIG. 8;
FIG. 10 is a schematic diagram of a structure of the conductive member in the structure shown in FIG. 9;
FIG. 11 is a schematic diagram of an orthographic projection of the conductive member shown in FIG. 10 on a first surface; and
FIG. 12 is a partial enlarged view of the electronic device shown in FIG. 8 at a region II.

### DESCRIPTION OF EMBODIMENTS

In the embodiments of this application, the terms "first", "second", "third", "fourth", "fifth", and "sixth" are used merely for the purpose of description, and shall not be construed as indicating or implying relative importance or implying a quantity of indicated technical features. Therefore, features defining "first", "second", "third", "fourth", "fifth", and "sixth" may explicitly or implicitly include one or more such features.

In the embodiments of this application, terms "include", "comprise", and any variants thereof are intended to cover a non-exclusive inclusion. Therefore, in the context of a process, method, object, or apparatus that includes a series of elements, the process, method, object, or apparatus not only includes such elements, but also includes other elements not specified expressly, or may include inherent elements of the process, method, object, or apparatus. Without more limitations, elements defined by a sentence "including one ..." does not exclude that there are still other same elements in the process, method, object, or apparatus.

In the embodiments of this application, the term "and/or" describes only an association relationship for describing associated objects and represents that three relationships may exist. For example, A and/or B may represent the following three cases: Only A exists, both A and B exist, and only B exists. In addition, the character "/" in this specification generally indicates an "or" relationship between associated objects.

In the embodiments of this application, the description that two components are "electrically conductive" means that when one of the two components is energized, the current on the component can enter the other component through an electrical conduction portion.

This application provides an electronic device. The electronic device may be a user equipment (user equipment, UE), a terminal (terminal), or the like. For example, the electronic device may be a mobile terminal or a stationary terminal, such as a tablet computer (portable android device, PAD), a laptop computer, a personal digital assistant (personal digital assistant, PDA), a handheld device having a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in smart grid (smart grid), a wireless terminal in transportation safety (transportation safety), a wireless terminal in a smart city (smart city), or a wireless terminal in a smart home (smart home). The electronic device includes at least two components, and the two components are in electrical conduction with each other through a conductive member. The following embodiments are described by using an example in which the electronic device is a foldable-screen device. The foldable-screen device may be, for example, a mobile phone.

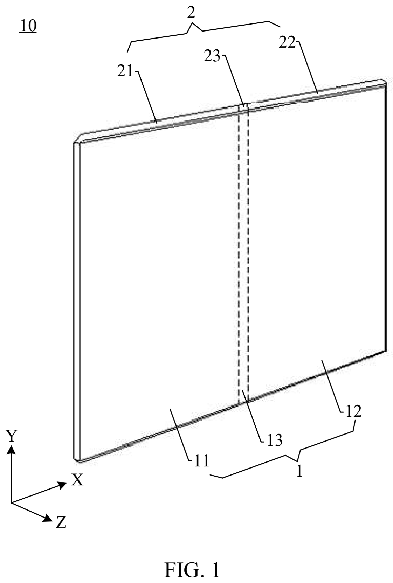

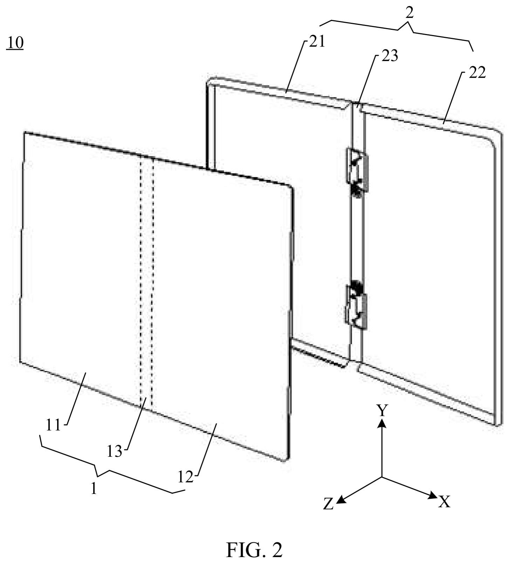

Referring to FIG. 1 and FIG. 2, FIG. 1 is a three-dimensional view of an electronic device 10 in an unfolded state according to some embodiments of this application, and FIG. 2 is a schematic partial exploded view of the electronic device 10 shown in FIG. 1. The electronic device 10 in the unfolded state is approximately in a shape of a rectangular flat panel. To facilitate the description of the following embodiments, an XYZ coordinate system is established for the electronic device 10 in the unfolded state. A length direction of the electronic device 10 is defined as an X-axis direction, a width direction of the electronic device 10 is defined as a Y-axis direction, and a thickness direction of the electronic device 10 is defined as a Z-axis direction. It may be understood that, the coordinate system of the electronic device 10 may be flexibly set based on an actual requirement. This is not specifically limited herein. In some other embodiments, the shape of the electronic device 10 in the unfolded state may also be a square flat panel, a circular flat panel, an oval flat panel, or the like.

The electronic device 10 includes a foldable screen 1 and a support apparatus 2.

The foldable screen 1 is configured to display information such as images and videos. The foldable screen 1 may be an organic light-emitting diode (organic light-emitting diode, OLED) screen, a micro organic light-emitting diode (micro organic light-emitting diode) screen, a quantum dot light emitting diode (quantum dot light emitting diode, QLED) screen, a liquid crystal display (liquid crystal display, LCD), or the like.

The foldable screen 1 has a display surface, and the display surface is exposed to present information such as images or videos to a user. The foldable screen 1 includes a first foldable-screen part 11, a second foldable-screen part 12, and a third foldable-screen part 13. The third foldable-screen part 13 is connected between the first foldable-screen part 11 and the second foldable-screen part 12. In the electronic device 10 shown in FIG. 1, the foldable screen 1 is in an unfolded state, and the first foldable-screen part 11, the third foldable-screen part 13, and the second foldable-screen part 12 are sequentially arranged along the X-axis direction. In this way, the electronic device 10 is folded along a transverse direction. In some other embodiments, when the foldable screen 1 is in the unfolded state, the first foldable-screen part 11, the third foldable-screen part 13, and the second foldable-screen part 12 may also be sequentially arranged along the Y-axis direction. In this way, the electronic device 10 is folded along a longitudinal direction. When the foldable screen 1 is in the unfolded state, large-screen display can be achieved, to provide richer information for the user and bring better user experience.

At least the third foldable-screen part 13 of the foldable screen 1 is of a flexible screen structure. In this way, the third foldable-screen part 13 may undergo a bending deformation under an external force, to fold the foldable screen 1 from the unfolded state shown in FIG. 1 to a folded state. The first foldable-screen part 11 and the second foldable-screen part 12 of the foldable screen 1 each may be of a flexible screen structure, or may be of a rigid screen structure, or may be partially of a flexible screen structure and partially of a rigid screen structure. This is not specifically limited herein.

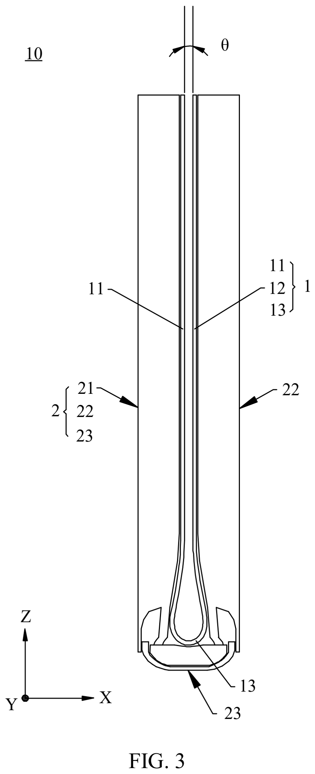

Referring to FIG. 3, FIG. 3 is a schematic diagram of a structure of the electronic device 10 shown in FIG. 1 in a folded state. The foldable screen 1 in the electronic device 10 is also in the folded state. Specifically, when the foldable screen 1 is in the folded state, the first foldable-screen part 11 and the second foldable-screen part 12 of the foldable screen 1 are approximately parallel and opposite to each other. An angle θ between the first foldable-screen part 11 and the second foldable-screen part 12 is within 30°, and it may be considered that the first foldable-screen part 11 and the second foldable-screen part 12 are approximately parallel. That the first foldable-screen part 11 and the second foldable-screen part 12 are opposite to each other means that a display surface of the first foldable-screen part 11 and a display surface of the second foldable-screen part 12 face each other.

The support apparatus 2 is located on a side of the foldable screen 1 that faces away from the display surface, and the support apparatus 2 is configured to bear the foldable screen 1.

The support apparatus 2 includes a first housing 21, a second housing 22, and a hinge mechanism 23. The first housing 21 bears the first foldable-screen part 11, and the second housing 22 bears the second foldable-screen part 12. The hinge mechanism 23 is connected between the first housing 21 and the second housing 22, and bears the third foldable-screen part 13. The hinge mechanism 23 is configured to implement revolution between the second housing 22 and the first housing 21, to support folding of the foldable screen 1 between the unfolded state and the folded state.

When the electronic device 10 is in the folded state, still referring to FIG. 3, the support apparatus 2 protects the foldable screen 1 from the outside, and the foldable screen 1 is invisible to the user, so that the foldable screen 1 can be prevented from being scratched by a hard object. The foldable-screen device is an inward folding screen device, and the size of the electronic device 10 is reduced, making it easy to carry.

In the foregoing embodiments, optionally, the first housing 21 may include a first middle frame and a first back cover that are connected together. The first foldable-screen part 11 is borne on the first middle frame, the first back cover is located on a side of the first middle frame that faces away from the first foldable-screen part 11, and the first back cover may be replaced with a display screen (for example, an LCD display screen). A first accommodating cavity is formed between the first middle frame and the first back cover. The first accommodating cavity is configured to accommodate components such as a first circuit board, a camera module, and a battery. These components are fixed to the first middle frame. Based on this, the first housing 21 may be connected to the hinge mechanism 23 by means of the first middle frame.

Similarly, the second housing 22 may also include a second middle frame and a second back cover that are connected together. The second foldable-screen part 12 is borne on the second middle frame, the second back cover is located on a side of the second middle frame that faces away from the second foldable-screen part 12, and the second back cover may be replaced with a display screen (for example, an LCD display screen). A second accommodating cavity is formed between the second middle frame and the second back cover. The second accommodating cavity is configured to accommodate components such as a second circuit board, a speaker module, an antenna element, and a battery. These components are fixed to the second middle frame. Based on this, the second housing 22 may be connected to the hinge mechanism 23 by means of the second middle frame.

It should be noted that, to distinguish the first middle frame from the second middle frame, in the descriptions of the following embodiments, the first middle frame is labeled as A in the figures, and the second middle frame is labeled as B in the figures.

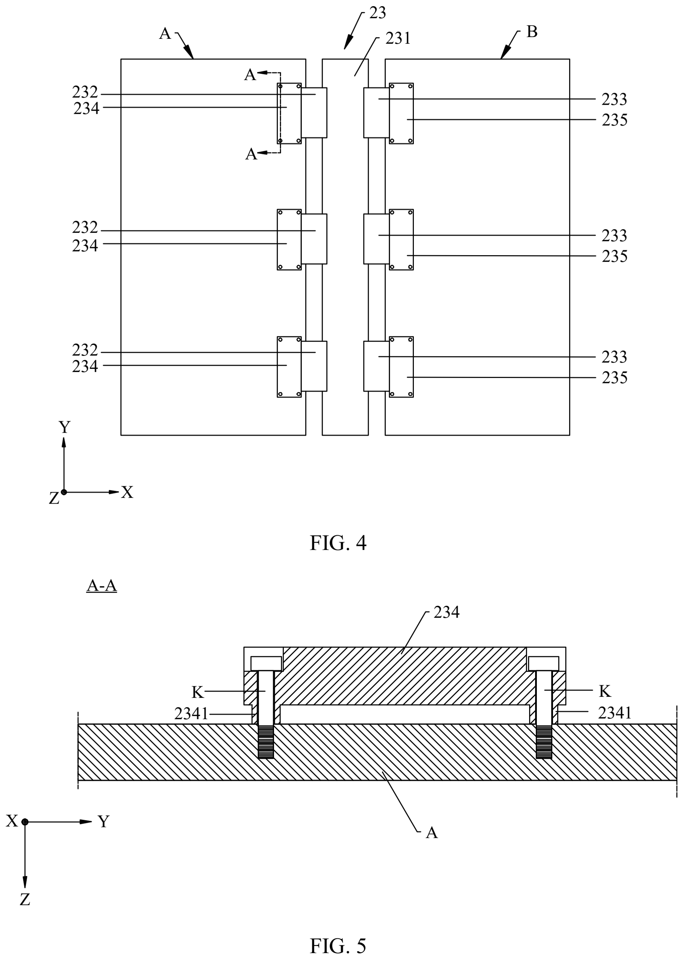

Referring to FIG. 4, FIG. 4 is a schematic diagram of a back surface structure of a first middle frame A, a second middle frame B, and a hinge mechanism 23 in the electronic device 10 shown in FIG. 1 and FIG. 2. The back surface refers to a surface of the first middle frame A, the second middle frame B, and the hinge mechanism 23 that faces away from the foldable screen 1.

According to the descriptions of the foregoing embodiments, the first middle frame A is configured to bear the first foldable-screen part 11 and fix the components within the first accommodating cavity, and the second middle frame B is configured to bear the second foldable-screen part 12 and fix the components within the second accommodating cavity. Therefore, the first middle frame A and the second middle frame B play a supporting role. Based on this, to ensure the supporting strength of the first middle frame A and the second middle frame B, the first middle frame A and the second middle frame B may be made of metal materials, such as aluminum alloy. In addition, the first middle frame A and the second middle frame B are further used as reference grounds, to meet signal return requirements for the components within the first containing cavity and the second containing cavity.

Some materials of the first middle frame A and the second middle frame B may further be used as radiators (not shown in the figure) of an antenna, to implement transmission and reception of a radio frequency signal.

Still referring to FIG. 4, the hinge mechanism 23 includes a base 231, a first swing arm 232, a second swing arm 233, a first connector 234, and a second connector 235.

It may be known that, FIG. 4 schematically shows some components included in the hinge mechanism 23. The components are shown in a simplified diagram in FIG. 4, and actual shapes, actual sizes, actual positions, and actual structures of the components are not limited. In some embodiments, in addition to the foregoing components, the hinge mechanism 23 may further include a shaft cover, a door panel, an auxiliary swing arm, and the like. Details are not described herein again in this application.

The base 231 provides a positional reference in the hinge mechanism 23, and the base 231 may also be referred to as a central beam. The first swing arm 232 and the second swing arm 233 may be rotatably connected to the base 231. There may be one or more first swing arms 232 and second swing arms 233. In the embodiment shown in FIG. 4, there are three first swing arms 232 and three second swing arms 233. A rotation axis of the first swing arm 232 relative to the base 231 is approximately parallel to a rotation axis of the second swing arm 233 relative to the base 231. "Approximately parallel" refers to parallelism that allows for an error range, with a deviation from absolute parallel parallelism being within 5°.

The first connector 234 and the second connector 235 are also referred to as wedge blocks.

The first connector 234 is connected to one end of the first swing arm 232 that is away from the base 231, and the first connector 234 is fixed to the first middle frame A. A connection manner of the first connector 234 and the first swing arm 232 includes, but is not limited to, a fixed connection, a sliding connection, and a rotation connection.

Similarly, the second connector 235 is connected to one end of the second swing arm 233 that is away from the base 231, and the second connector 235 is fixed to the second middle frame B. A connection manner of the second connector 235 and the second swing arm 233 includes, but is not limited to, a fixed connection, a sliding connection, and a rotation connection.

When subjected to a force from the user, the first middle frame A and the second middle frame B may drive the first swing arm 232 and the second swing arm 233 to rotate relative to the base 231, enabling the electronic device 10 to switch between the unfolded state and the folded state.

To ensure the life of the electronic device 10 and improve the reliability of movement of the hinge mechanism 23, the hinge mechanism 23 is usually made of metal materials. For example, the hinge mechanism 23 is made of a steel material, and the steel material includes, but is not limited to, stainless steel.

Based on the foregoing embodiments, the hinge mechanism 23 may be in electrical conduction with the first middle frame A and the second middle frame B, to prevent the hinge mechanism 23 from absorbing the radiation efficiency of the antennas on the first middle frame A and the second middle frame B. In addition, the hinge mechanism 23 is in electrical conduction with the first middle frame A and the second middle frame B, and can also discharge static electricity on the hinge mechanism 23 to the first middle frame A and the second middle frame B, to avoid micro-sparking, thereby preventing interference with the electronic components such as the first circuit board, the second circuit board, the camera module, and the display screen within the electronic device 10. In addition, the hinge mechanism 23 is in electrical conduction with the first middle frame A and the second middle frame B, and the first middle frame A and the second middle frame B may also be set to a same potential, to prevent the generation of a potential difference between the first middle frame A and the second middle frame B, thereby preventing the generation of an electric field between the first middle frame A and the second middle frame B, and further preventing interference with a radio frequency signal and a baseband signal transmitted on a flexible printed circuit (flexible printed circuit, FPC). The FPC is connected between the first circuit board within the first accommodating cavity and the second circuit board within the second accommodating cavity, and passes through the hinge mechanism 23.

To achieve the foregoing objective, while being fixed to the first middle frame A, the first connector 234 is further in electrical conduction with the first middle frame A, and while being fixed to the second middle frame B, the second connector 235 is further in electrical conduction with the second middle frame B.

Specifically, referring to FIG. 5, FIG. 5 is a schematic diagram of a cross-sectional structure of an assembly structure shown in FIG. 4 along a direction A-A. The first middle frame A and the first connector 234 are fastened and fixed by using a screw K, and a surface of the first connector 234 that faces the first middle frame A is provided with a boss 2341. The boss 2341 and the first connector 234 are integrally formed and made of a same material, which is steel. The screw K is inserted through the boss 2341. Therefore, the boss 2341 can be brought into close contact with the first middle frame A by a fastening force of the screw K, to implement electrical conduction between the first middle frame A and the first connector 234.

Similarly, a connection manner of the second connector 235 and the second middle frame B may be implemented with reference to a fixing manner of the first connector 234 and the first middle frame A. Details are not described herein again.

With the development of technologies, the electronic device 10 is required to have a smaller weight. To reduce the weight, the first middle frame A and the second middle frame B within the electronic device may be formed by using magnesium alloy. Magnesium alloy is alloy that is formed by adding other elements based on magnesium. Magnesium alloy has low density, good rigidity and high strength, which can ensure the structural strength of the first middle frame A and the second middle frame B while reducing the weight. In addition, raw material resources of magnesium alloy are abundant, thereby helping reduce the costs of the electronic device.

However, magnesium alloy has very high chemical reactivity and a very low equilibrium potential. In a humid or solution environment, it is prone to galvanic corrosion when in contact with different types of metals. In addition, the hinge mechanism 23 is a motion mechanism, which is difficult to seal. Humid air or water outside the electronic device can easily enter the space in which the hinge mechanism 23 is located, and further enters a gap between the first connector 234 and the first middle frame A and a gap between the second connector 235 and the second middle frame B. In addition, based on the foregoing descriptions, a material of the boss 2341 is a steel material, and the material of the boss 2341 is different from a material of the first middle frame A and a material of the second middle frame B. Therefore, corrosion may occur at a portion on the first middle frame A that is in contact with the boss 2341 and a portion on the second middle frame B that is in contact with a boss of the second connector 235. After the corrosion of magnesium alloy, the impedance increases, leading to a reduction in the reliability of the electrical connection.

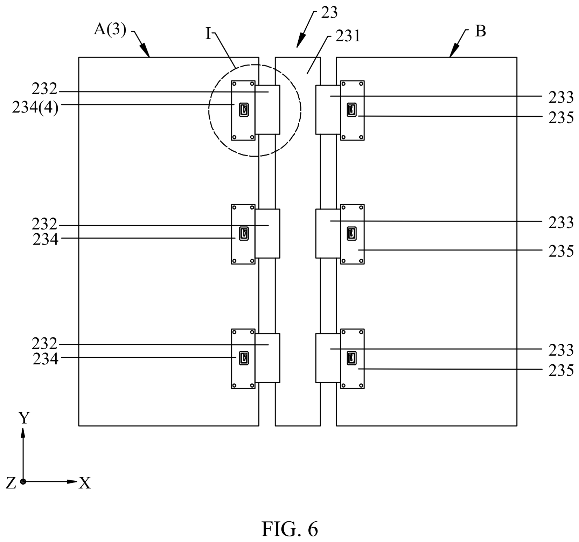

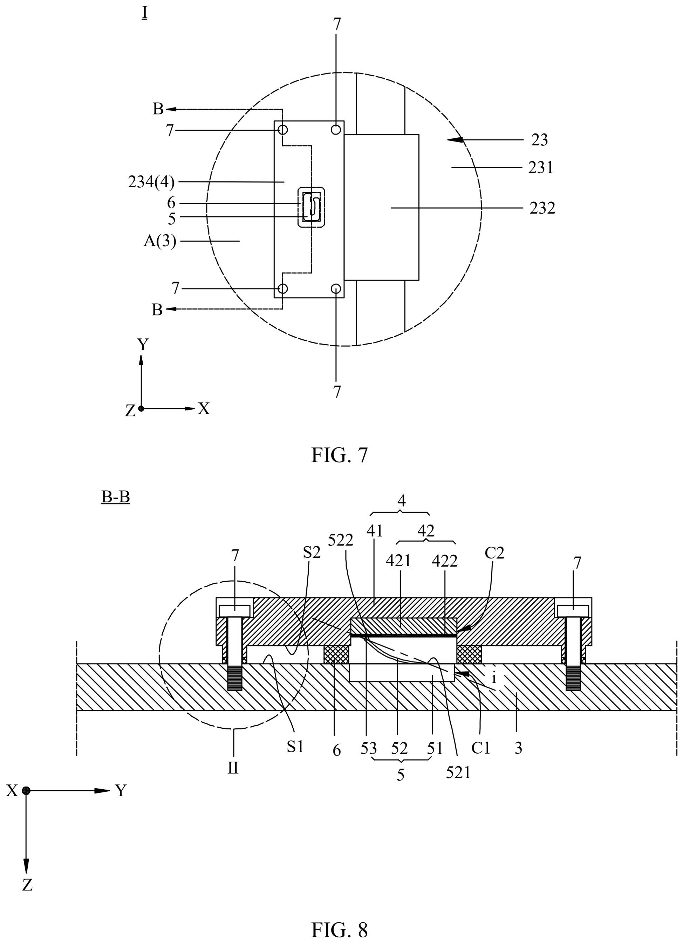

To resolve the foregoing problem, referring to FIG. 6 to FIG. 8, FIG. 6 is a schematic diagram of a partial structure of the electronic device 10 according to some embodiments of this application, FIG. 7 is a partial enlarged view of a region I of the electronic device 10 shown in FIG. 6, and FIG. 8 is a schematic diagram of a cross-sectional structure of the electronic device 10 shown in FIG. 7 along a direction B-B. In this embodiment, the electronic device 10 includes a first component 3 and a second component 4.

The first component 3 and the second component 4 may be in a plate shape, a sheet shape, a block shape, or the like. This application provides a description by using an example in which both the first component 3 and the second component 4 are in a plate shape. In addition, materials of the first component 3 and the second component 4 are conductive materials. Specifically, materials of the first component 3 and the second component 4 may be conductive metals.

In some embodiments, referring to FIG. 6 and FIG. 7, the first component 3 may be the first middle frame A, and the second component 4 may be the first connector 234.

In some other embodiments, the first component 3 may alternatively be the first connector 234, and the second component 4 is the first middle frame A, or the first component 3 is the second middle frame B, and the second component 4 is the second connector 235, or the first component 3 is the second connector 235, and the second component 4 is the second middle frame B.

In some other embodiments, when the electronic device 10 is a product other than a folded-screen device, the first component 3 and the second component 4 may alternatively be other components.

This embodiment and the following embodiments are described by using an example in which the first component 3 is the first middle frame A and the second component 4 is the first connector 234. This cannot be considered as a special limitation to structural forms of the first component 3 and the second component 4.

Referring to FIG. 7 and FIG. 8 mainly, the electronic device 10 further includes a conductive member 5 and a sealing ring 6.

The conductive member 5 is arranged between the first component 3 and the second component 4, and is in electrical conduction with the first component 3 and the second component 4.

The sealing ring 6 is arranged between the first component 3 and the second component 4, one end of the sealing ring 6 in an axial direction faces the first component 3, and the other end of the sealing ring 6 faces the second component 4.

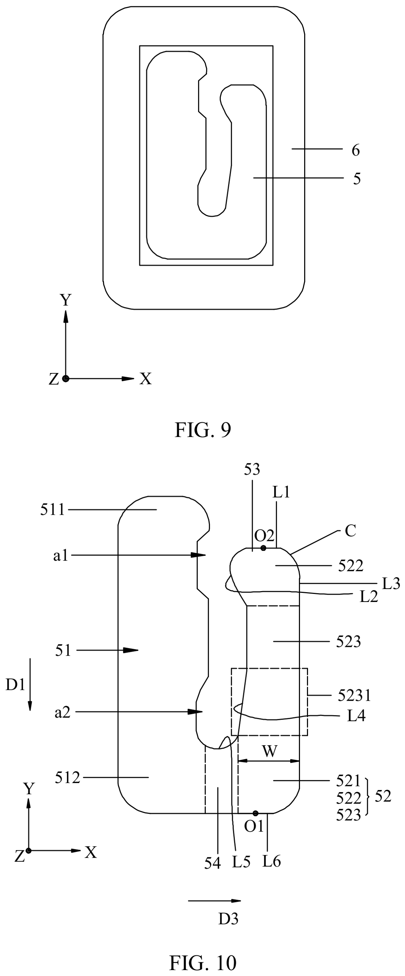

A material of the sealing ring 6 includes, but is not limited to, foam, rubber and silica gel. The axial direction of the sealing ring 6 refers to an extension direction of a central axis of a cylindrical space surrounded by the sealing ring 6. A shape of the sealing ring 6 may be a circle, a square, a polygon, a triangle, a rectangle, or the like. Referring to FIG. 9, FIG. 9 is a top view of the conductive member 5 and the sealing ring 6 in the electronic device 10 shown in FIG. 8. The shape of the sealing ring 6 is approximately a rectangle.

In some embodiments, referring to FIG. 8, a surface of the first component 3 that faces the second component 4 is defined as a first surface S1, a surface of the second component 4 that faces the first component 3 is defined as a second surface S2, and the first sealing ring 6 is arranged between the first surface S1 and the second surface S2.

Based on the foregoing descriptions, the sealing ring 6 may be fixed on the first surface through a process such as adhesive bonding or heat pressing, and the sealing ring 6 is in contact with but not connected to the second surface S2. Alternatively, the sealing ring 6 is fixed on the second surface S2 through a process such as adhesive bonding or heat pressing, and the sealing ring 6 is in contact with but not connected to the first surface S1. This makes it easy to separate the first component 3 and the second component 4 for maintenance, and facilitates the installation of the sealing ring 6 between the first component 3 and the second component 4. In addition, the position of the sealing ring 6 between the first component 3 and the second component 4 can be fixed, preventing misalignment of the sealing ring 6.

In some other embodiments, the first surface S1 and/or the second surface S2 may be provided with an annular limiting groove, and at least a portion of the sealing ring 6 is accommodated within the annular limiting groove. Therefore, the annular limiting groove can help limit the sealing ring 6, thereby also preventing misalignment of the sealing ring 6.

Based on the foregoing descriptions, referring to FIG. 9, the conductive member 5 is located within a region surrounded by the sealing ring 6.

In this way, the conductive member 5 can help implement electrical conduction between the first component 3 and the second component 4, and the sealing ring 6 can help seal an electrical conduction portion between the first component 3 and the second component 4, preventing moisture ingress and preventing corrosion, thereby ensuring the reliability of the electrical connection. This enables the first component 3 or the second component 4 to be made of metals with active chemical properties, such as magnesium alloy, thereby expanding the material selection range for the first component 3 and the second component 4, and helping reduce the weight of the electronic device 10.

Based on the foregoing descriptions, optionally, a material of at least one of the first component 3 or the second component 4 is magnesium alloy. Magnesium alloy has low density, and good structural strength and rigidity, thereby helping reduce the weight of the electronic device 10 and ensuring the structural strength and service life of the electronic device 10.

The conductive member 5 includes, but is not limited to, a conductive boss, a conductive gasket, a conductive elastic piece, a conductive spring, and the like. A material of the conductive member 5 includes, but is not limited to, a metal such as stainless steel, spring steel, aluminum alloy, magnesium alloy, or titanium alloy, or a non-metal such as graphite or graphene. Alternatively, the conductive member 5 may be rubber doped with metal particles or graphite particles.

Since the conductive member 5 is located in the region surrounded by the sealing ring 6, the area occupied by the conductive member 5 in the XY plane affects the size of the sealing ring 6. Specifically, a smaller area occupied by the conductive member 5 in the XY plane indicates a smaller sealing ring 6, resulting in a smaller impact on the sizes of the first component 3 and the second component 4 in the XY plane. In addition, since the conductive member 5 is located between the first component 3 and the second component 4, the height of the conductive member 5 in the Z-axis direction affects the height of the sealing ring 6, and also affects the stack thickness of the first component 3 and the second component 4. Specifically, a smaller height of the conductive member 5 in the Z-axis direction indicates a smaller height of the sealing ring 6, which reduces material costs and sealing difficulty. The stack thickness of the first component 3 and the second component 4 becomes smaller, which is more beneficial to the thinning of the electronic device.

In some embodiments, still referring to FIG. 8 and FIG. 9, the conductive member 5 is a conductive elastic piece. The conductive elastic piece has a small volume, which facilitates the installation between the first component 3 and the second component 4 with limited space, and is also beneficial to the thinning of the electronic device, thereby avoiding an impact on the sizes of the first component 3 and the second component 4.

The conductive elastic piece has a plurality of structural forms. In some embodiments, referring to FIG. 8, the conductive elastic piece includes a fixed portion 51, an elastic arm portion 52, and a contact portion 53.

The fixed portion 51 is fixed to and in electrical conduction with the first component 3. In some embodiments, the fixed portion 51 may be fixed to and in electrical conduction with the first component 3 through spot welding, or may be fixed to and in electrical conduction with the first component 3 by using conductive adhesive. This application provides a description by using an example in which the fixed portion 51 is fixed to and in electrical conduction with the first component 3 through spot welding. This cannot be considered as a special limitation to this application.

In some embodiments, still referring to FIG. 8, the first surface S1 is provided with a first recessed groove C1, and at least the fixed portion 51 of the conductive elastic piece is accommodated within the first recessed groove C1. In this way, under the premise of a fixed height of a gap between the first component 3 and the second component 4, the height of the conductive elastic piece in the Z-axis direction can be increased to improve the structural strength and elasticity of the conductive elastic piece.

Based on the foregoing descriptions, the fixed portion 51 is specifically fixed to a bottom surface of the first recessed groove C1 through spot welding, and is in electrical conduction with the first component 3.

In some embodiments, still referring to FIG. 8, the first recessed groove C1 may be provided within a region surrounded by the sealing ring 6 on the first surface S1. This can prevent the generation of a step difference at the position for arranging the sealing ring 6 on the first surface S1, thereby ensuring the sealing performance of the sealing ring 6 and preventing corrosion.

In some embodiments, a depth of the first recessed groove C1 may be greater than or equal to 0.1 mm and less than or equal to 0.2 mm. Specifically, the depth of the first recessed groove C1 may be 0.1 mm, 0.12 mm, 0.14 mm, 0.16 mm, 0.18 mm, or 0.2 mm. When the depth of the first recessed groove C1 is within this range, the depth of the first recessed groove C1 is moderate, which allows for an increase in the height of the conductive elastic piece in the Z-axis direction while avoiding an impact on the structural strength of the first component 3.

The contact portion 53 is in contact with and in electrical conduction with the second component 4. In some embodiments, the contact portion 53 may include a contact portion main body and a first contact layer (not shown in the figure). The first contact layer is arranged on a surface of the contact portion main body, and an electrical conductivity of the first contact layer is higher than that of the contact portion main body. The first contact layer is in contact with the second component 4.

In this way, the first contact layer can help improve the conductive efficiency between the contact portion main body and the second component 4, and reduce impedance and passive inter-modulation (passive inter-modulation, PIM) characteristics.

In the foregoing embodiments, a material of the first contact layer includes, but is not limited to, at least one of gold, nickel, silver, or copper. In some embodiments, the material of the first contact layer is gold. The gold has high electrical conductivity, which can greatly improve the conductive efficiency between the contact portion main body and the second component 4, and reduce the impedance and the PIM characteristics.

The first contact layer may be formed on a surface of the contact portion main body through a process such as electroplating, vacuum plating, and thermal spraying. This is not specifically limited in this application.

Still referring to FIG. 8, the elastic arm portion 52 includes a first end portion 521 and a second end portion 522 that are opposite to each other. A direction from the first end portion 521 to the second end portion 522 is inclined relative to the first surface S1. The direction from the first end portion 521 to the second end portion 522 is parallel to a line i connecting the first end portion 521 and the second end portion 522 in FIG. 8. Specifically, an inclined angle of the direction from the first end portion 521 to the second end portion 522 relative to the first surface S1 may be greater than 0° and less than 90°, and may be specifically 15°, 30°, 45°, 60°, 80°, or the like. This is not specifically limited in this application.

It should be noted that, in the foregoing embodiments and the following embodiments, two opposite "end portions" described in a component refer to portions adjacent to two opposite edges of the component respectively, where one edge is located on a side of one end portion that is away from the other end portion, and the other edge is located on a side of the other end portion that is away from the one end portion. Based on this, in the two end portions, a direction from one end portion to the other end portion refers to a direction from a midpoint of one edge to a midpoint of the other edge.

For example, referring to FIG. 10, FIG. 10 is a schematic diagram of a structure of the conductive member 5 in the structure shown in FIG. 9. The elastic arm portion 52 includes a sixth edge L6 and a first edge L1 that are opposite to each other. The sixth edge L6 is located on a side of the first end portion 521 that is away from the second end portion 522, and is adjacent to the first end portion 521. The first edge L1 is located on a side of the second end portion 522 that is away from the first end portion 521, and is adjacent to the second end portion 522. Based on this, the direction from the first end portion 521 to the second end portion 522 refers to a direction from a midpoint O1 of the sixth edge L6 to a midpoint O2 of the first edge L1. In the following embodiments, the same descriptions should be understood in the same way. Details are not described again.

Based on the foregoing descriptions, the first end portion 521 is connected to and in electrical conduction with the fixed portion 51. The second end portion 522 is connected to and in electrical conduction with the contact portion 53. Specifically, the second end portion 522 is connected to and in electrical conduction with the contact portion main body of the contact portion 53.

In this way, during an installation process of the conductive elastic piece between the first component 3 and the second component 4, the elastic arm portion 52 can undergo a bending deformation toward the first component 3, thereby storing an elastic force. This elastic force enables the contact portion 53 to maintain stable contact against the second component 4, thereby ensuring the contact reliability between the contact portion 53 and the second component 4. In addition, the conductive elastic piece can also adapt for installation between different gaps, and the conductive elastic piece has a small thickness, and can be installed in gaps with limited height without affecting the thickness of the electronic device, which is beneficial to the thinning of the electronic device.

It may be understood that, the size of the conductive elastic piece affects the sizes of the first component 3 and the second component 4, and the thickness of the electronic device. Specifically, a larger orthographic projection area of the conductive elastic piece in the XY plane indicates that the first component 3 and the second component 4 need to be designed with larger sizes in the X-axis direction and in the Y-axis direction, so that the first component 3 and the second component 4 can cover the conductive elastic piece, thereby preventing the conductive elastic piece from being exposed, and facilitating a stable electrical connection between the first component 3 and the second component 4. A larger height of the conductive elastic piece in the Z-axis direction indicates a larger stack thickness of the first component 3, the conductive elastic piece, and the second component 4 in the Z-axis direction, which is less beneficial to the thin design of the electronic device.

Based on this, in some embodiments, still referring to FIG. 10, the fixed portion 51 includes a third end portion 511 and a fourth end portion 512 that are opposite to each other. A direction from the third end portion 511 to the fourth end portion 512 is a first direction D1, and the first direction D1 is parallel to the first surface S1. For example, referring to FIG. 10, the first direction D1 is opposite to the Y-axis direction.

Based on the foregoing descriptions, still referring to FIG. 10, the first end portion 521 is connected to and in electrical conduction with the fourth end portion 512.

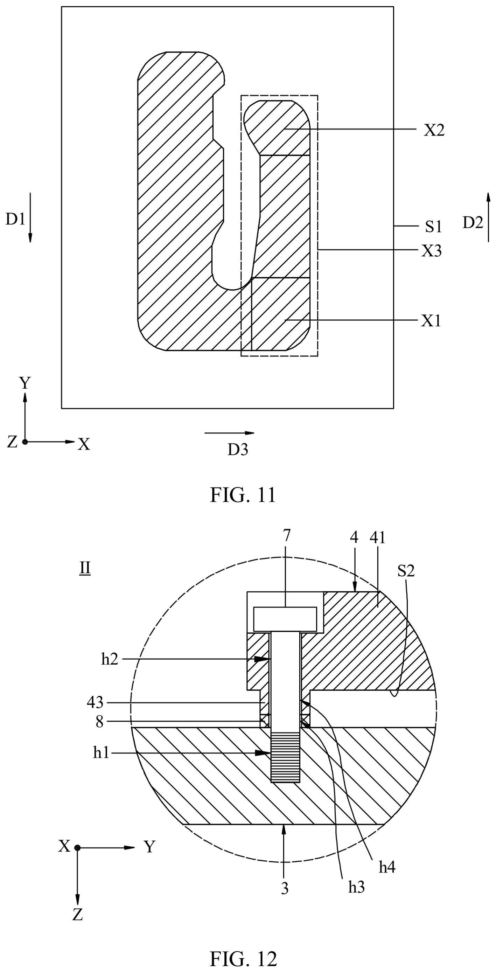

Referring to FIG. 11, FIG. 11 is a schematic diagram of an orthographic projection of the conductive member 5 shown in FIG. 10 on a first surface S1. An orthographic projection of the first end portion 521 on the first surface S1 is a first orthographic projection X1, an orthographic projection of the second end portion 522 on the first surface S1 is a second orthographic projection X2, a direction from the first orthographic projection X1 to the second orthographic projection X2 is a second direction D2, and the second direction D2 is opposite to the first direction D1. The "opposite" is not limited to opposite in an absolute sense, but refers to being approximately opposite within an allowed error range.

In this way, along a path of the third end portion 511 → the fourth end portion 512 → the first end portion 521 → the second end portion 522, the conductive elastic piece undergoes at least one reverse bending. This can reduce the size of the conductive elastic piece in the first direction D1, preventing the first component 3 and the second component 4 from being designed with excessively large sizes in the first direction D1, thereby helping reduce the size of the electronic device.

Based on the foregoing embodiments, a direction parallel to the first surface S1 and perpendicular to the first direction D1 is defined as a third direction D3, and the fixed portion 51 and the elastic arm portion 52 may be arranged along the Z-axis direction, or may be arranged along the third direction D3. This is not specifically limited in this application.

In some embodiments, still referring to FIG. 10, the fixed portion 51 and the elastic arm portion 52 are arranged spaced apart along the third direction D3.

In this way, an orthographic projection region of the fixed portion 51 on the first surface S1 does not overlap with an orthographic projection region of the elastic arm portion 52 on the first surface S1. This can prevent thickness stacking between the fixed portion 51 and the elastic arm portion 52 in the Z-axis direction, thereby helping reduce the height of the conductive elastic piece in the Z-axis direction. Therefore, it can reduce the stack thickness of the first component 3, the conductive elastic piece, and the second component 4 in the Z-axis direction, which is beneficial to the thinning of the electronic device.

In some embodiments, still referring to FIG. 10, the conductive elastic piece further includes a connecting portion 54. The connecting portion 54 is located between the fourth end portion 512 and the first end portion 521, and the connecting portion 54 is connected to and in electrical conduction with both the fourth end portion 512 and the first end portion 521. Based on this, the connecting portion 54 extends along the third direction D3 from the fourth end portion 512 to the first end portion 521.

In this way, the fourth end portion 512 and the first end portion 521 are aligned in the third direction D3, thereby further reducing the size of the conductive elastic piece in the first direction D1.

In some embodiments, referring to FIG. 10 and FIG. 11 together, an orthographic projection of the elastic arm portion 52 on the first surface S1 is a third projection X3, and a length of the third projection X3 in the first direction D1 is less than a length of the fixed portion 51 in the first direction D1.

In this way, since the contact portion 53 is connected to the second end portion 522, under the premise that the fourth end portion 512 and the first end portion 521 are aligned in the third direction D3, the contact portion 53 is located at a middle position of the conductive elastic piece in the first direction D1. A region surrounded by the sealing ring 6 on the second surface S2 is defined as a first region, so that the contact portion 53 can be brought into contact with the first region at the middle position in the first direction D1, thereby further ensuring the reliability of the electrical connection.

Based on the foregoing embodiments, the contact portion 53 may be arranged on a side of the second end portion 522 that is away from the first end portion 521, may be arranged on the second end portion 522, may be arranged on a side of the second end portion 522 that faces the fixed portion 51, or may be arranged on a side of the second end portion 522 that faces away from the fixed portion 51.

In some embodiments, referring to FIG. 10, an edge of the second end portion 522 that is away from the first end portion 521 is a first edge L1, and a portion of the second end portion 522 on which the first edge L1 is located forms the contact portion 53. In this way, the conductive elastic piece is simple in structure and is easy to manufacture.

Based on the foregoing embodiments, optionally, referring to FIG. 10, an edge of the second end portion 522 that faces the fixed portion 51 is a second edge L2, and the second edge L2 is a flange protruding toward the fixed portion 51. An edge of the second end portion 522 that is away from the fixed portion 51 is a third edge L3, and an arc transition edge or an inclined transition edge is connected between the third edge L3 and the first edge L1.

When the arc transition edge C is connected between the third edge L3 and the first edge L1, referring to FIG. 10, the arc transition edge C protrudes toward a direction away from the fixed portion 51, and the arc transition edge C is tangent to both the first edge L1 and the third edge L3.

When the inclined transition edge is connected between the third edge L3 and the first edge L1, one end of the inclined transition edge is connected to the third edge L3, the other end of the inclined transition edge extends in a direction away from the first end portion 521 and is inclined to the fixed portion 51, and the other end is connected to the first edge L1.

In this way, in the third direction D3, the contact portion 53 is closer to the fixed portion 51, that is, the contact portion 53 is located at a middle position of the conductive elastic piece in the third direction D3, so that the contact portion 53 can be brought into contact with the first region at the middle position in the third direction D3, thereby helping ensure the stability and reliability of the electrical connection.

In some embodiments, referring to FIG. 10, an edge of the fixed portion 51 that faces the elastic arm portion 52 is provided with a first clearance notch a1. When the elastic arm portion 52 bends toward the first component 3 to be coplanar with the fixed portion 51, the first clearance notch a1 is opposite to the second edge L2 along the third direction D3.

In this way, the first clearance notch a1 can help create clearance for the portion of the second end portion 522 at the second edge L2, preventing thickness stacking between the elastic arm portion 52 and the fixed portion 51 in the Z-axis direction when the elastic arm portion 52 bends to be coplanar with the fixed portion 51, thereby helping further reduce the thickness of the conductive elastic piece. In addition, the first clearance notch a1 can help create clearance for the elastic arm portion 522, thereby reducing the distance between the elastic arm portion 52 and the fixed portion 51 in the third direction D3, and decreasing the size of the conductive elastic piece in the third direction D3.

It may be known that, the elastic force of the conductive elastic piece is generated by deformation of the elastic arm portion 52. Still referring to FIG. 10, a portion on the elastic arm portion 52 that is located between the first end portion 521 and the second end portion 522 is defined as an intermediate portion 523, and the structural strength of the elastic arm portion 52 is determined by a width W of the junction between the first end portion 521 and the intermediate portion 523. A larger width W indicates higher structural strength of the elastic arm portion 522, making it less prone to deformation and capable of generating a larger elastic force after deformation.

Based on this, in some embodiments, still referring to FIG. 10, the elastic arm portion 52 further includes an intermediate section 5231. The intermediate section 5231 is connected between the first end portion 521 and the second end portion 522.

The intermediate section 5231 may be a section of the intermediate portion 523, or may be an entirety of the intermediate portion 523. This application provides a description by using an example in which the intermediate section 5231 is a section of the intermediate portion 523.

Still referring to FIG. 10, an edge of the intermediate section 5231 that faces the fixed portion 51 is defined as a fourth edge L4, and an edge of the connecting portion 54 that faces a gap between the intermediate section 5231 and the fixed portion 51 is defined as a fifth edge L5. The fourth edge L4 is connected to the fifth edge L5, and the fourth edge L4 is inclined to the fixed portion 51 along a direction from the second end portion 522 to the first end portion 521.

In this way, the width W of the junction between the first end portion 521 and the intermediate portion 523 is large, and the elastic arm portion 52 has high structural strength and a large elastic force, enabling reliable contact between the contact portion 53 and the second component 4.

Based on the foregoing embodiments, still referring to FIG. 10, an edge of the fixed portion 51 that faces the elastic arm portion 52 is provided with a second clearance notch a2. When the elastic arm portion 52 bends toward the first component 3 to be coplanar with the fixed portion 51, the second clearance notch a2 is opposite to the fourth edge L4 along the third direction D3.

In this way, the second clearance notch a2 can help create clearance for the portion of the intermediate section 5231 at the fourth edge L4, preventing thickness stacking between the elastic arm portion 52 and the fixed portion 51 in the Z-axis direction when the elastic arm portion 52 bends to be coplanar with the fixed portion 51, thereby helping further reduce the thickness of the conductive elastic piece. In addition, the second clearance notch a2 can help create clearance for the portion of the intermediate section 5231 at the fourth edge L4, thereby reducing the distance between the elastic arm portion 52 and the fixed portion 51 in the third direction D3, and decreasing the size of the conductive elastic piece in the third direction D3.

In some embodiments, referring to FIG. 10, the fixed portion 51, the connecting portion 54, the elastic arm portion 52, and the contact portion main body may be integrally formed, or may be fixed by welding. This application provides a description by using an example in which the fixed portion 51, the connecting portion 54, the elastic arm portion 52, and the contact portion main body are integrally formed. This cannot be considered as a special limitation to this application.

In some embodiments, referring to FIG. 8 and FIG. 10 together, the fixed portion 51, the connecting portion 54, and the first end portion 521 of the elastic arm portion 52 may be accommodated within the first recessed groove C1, and the fixed portion 51 is fixed to the bottom surface of the first recessed groove C1. This structure is simple and easy to implement.

Based on any one of the foregoing embodiments, the second component 4 may be an integral structural member, or may be assembled by a plurality of structural members. This is not specifically limited in this application.

In some embodiments, referring back to FIG. 8, the second component 4 may include a component body 41 and a contact member 42. The contact member 42 is fixed to and in electrical conduction with the component body 41, and the contact portion 53 is in contact with the contact member 42.

In this way, the second component 4 is assembled by the component body 41 and the contact member 42. The component body 41 and the contact member 42 can be made of different materials. For example, the component body 41 can be made of a material with high structural strength and low costs (such as stainless steel), and the contact member 42 can be made of a material with an electrical conductivity higher than the component body 41, thereby balancing manufacturing costs and conductive efficiency.

In the foregoing embodiments, the contact member 42 may be recessed within the component body 41, or may be protruded on a surface of the component body 41. In some embodiments, still referring to FIG. 8, a surface of the component body 41 that faces the first component 3 is provided with a second recessed groove C2. The contact member 42 is accommodated within the second recessed groove C2.

In this way, the contact member 42 is recessed within the component body 41, preventing thickness stacking between the component body 41 and the contact member 42, which is beneficial to the thinning of the electronic device. In addition, the contact member 42 not only can be in contact with a bottom surface of the second recessed groove C2, but also can be brought into contact with a side surface of the second recessed groove C2. Therefore, the contact area between the contact member 42 and the component body 41 is large, which can improve the conductive efficiency between the contact member 42 and the component body 41.

In some embodiments, the contact member 42 may be fixed to the bottom surface of the second recessed groove C2 through a process such as spot welding or conductive adhesive bonding. This connection manner is simple and easy to operate.

In the foregoing embodiments, the surface of the component body 41 that faces the first component 3 and the surface of the contact member 42 that faces the first component 3 are joined to form the second surface S2. Based on this, the second recessed groove C2 is provided within a region surrounded by the sealing ring 6 on the second surface S2. This can prevent the generation of a step difference at the position for arranging the sealing ring 6 on the second surface S2, thereby ensuring the sealing performance of the sealing ring 6 and preventing corrosion.

In some embodiments, referring to FIG. 8, a depth of the second recessed groove C2 is greater than or equal to 0.1 mm and less than or equal to 0.2 mm. Specifically, the depth of the second recessed groove C2 may be 0.1 mm, 0.12 mm, 0.14 mm, 0.16 mm, 0.18 mm, or 0.2 mm. When the depth of the second recessed groove C2 is within this range, the depth of the second recessed groove C2 is moderate, which is beneficial to the thinning of the electronic device while avoiding an impact on the structural strength of the component body 41.

In some embodiments, referring to FIG. 8, a thickness of the contact member 42 may be greater than or equal to 0.05 mm and less than or equal to 0.15 mm. In this way, the thickness of the contact member 42 is moderate, which can ensure the structural strength of the contact member 42 while allowing the contact member 42 to be recessed within the second recessed groove C2.

In some embodiments, the contact member 42 may be made of a same material, or may be made of a plurality of materials. In some embodiments, still referring to FIG. 8, the contact member 42 may include a contact member body 421 and a second contact layer 422. The second contact layer 422 is at least arranged on a surface of the contact member body 421 that faces the first component 3, and an electrical conductivity of the second contact layer 422 is higher than that of the contact member body 421. Based on this, the second end portion 522 is in contact with and in electrical conduction with the second contact layer 422. In this way, the second contact layer 422 can help improve the conductive efficiency between the contact portion main body and the second component 4, and reduce the impedance and the PIM characteristics.

A material of the contact member body 421 includes, but is not limited to, copper, copper alloy, aluminum alloy, magnesium alloy, and the like. In some embodiments, the electrical conductivity of the contact member body 421 is higher than the electrical conductivity of the component body 41. In this way, the conductive efficiency between the contact member body 421 the component body 41 can be improved, and the impedance and the PIM characteristics can be reduced.

A material of the second contact layer 422 includes, but is not limited to, at least one of gold, nickel, silver, or copper. In some embodiments, the material of the second contact layer 422 is gold. The gold has high electrical conductivity, which can greatly improve the conductive efficiency between the conductive member 5 and the second component 4, and reduce the impedance and the PIM characteristics.

The second contact layer 422 may be arranged only on the surface of the contact member body 421 that faces the first component 3, and not on other surfaces of the contact member body 421. Alternatively, the second contact layer 422 may be arranged on all surfaces of the contact member body 421, or on at least two surfaces including the surface that faces the first component 3. This is not specifically limited in this application. This application provides a description by using an example in which the second contact layer 422 is arranged only on the surface of the contact member body 421 that faces the first component 3. This cannot be considered as a special limitation to this application.

The first component 3 is fixedly connected to the second component 4. In some embodiments, referring back to FIG. 7, the electronic device 10 further includes at least one fixing member 7. "At least one" indicates one or more than two. The at least one fixing member 7 is connected between the first component 3 and the second component 4. The first component 3 is fixedly connected to the second component 4 by means of the at least one fixing member 7.

Based on the foregoing descriptions, optionally, the at least one fixing member 7 is located on a side of the sealing ring 6 that faces away from the conductive member 5.

In this way, the conductive member 5 and the sealing ring 6 are not limited by the position of the fixing member 7, and the conductive member 5 and the sealing ring 6 can be arranged at positions with sufficient space, thereby avoiding an impact on the size of the second component 4 and the connection stability between the first component 3 and the second component 4.

In the foregoing embodiments, there may be one or more fixing members 7. In some embodiments, referring to FIG. 7, there are a plurality of fixing members 7, and the plurality of fixing members 7 are connected between the edge of the second component 4 and the first component 3. The conductive member 5 and the sealing ring 6 are located on a side of a plurality of fixed portions 7 that faces a center of the second component 4.

In this way, the spacing between the plurality of fixing members 7 is large, and when the hinge mechanism 23 rotates, the resistance arm of the plurality of fixing members 7 is large, resulting in a large resistance torque. This can effectively prevent the separation of the second component 4 from the first component 3, thereby ensuring the connection stability between the second component 4 and the first component 3. In addition, since the conductive member 5 and the sealing ring 6 are located on the side of the plurality of fixed portions 7 that faces the center of the second component 4, it can prevent the conductive member 5 and the sealing ring 6 from affecting the size of the second component 4 and the connection stability between the first component 3 and the second component 4.

In any one of the foregoing embodiments, the fixing member 7 includes, but is not limited to, a screw, a bolt, a rivet, and a clip. This application provides a description by using an example in which the fixing member 7 is the screw. When the fixing member 7 is the screw, the connection stability and the reliability between the first component 3 and the second component 4 are good. In addition, a threaded surface of the screw can be provided with an insulating coating, and the insulating coating can prevent the first component 3 and the second component 4 from being electrically connected through the screw.

Specifically, referring to FIG. 12, FIG. 12 is a partial enlarged view of the electronic device 10 shown in FIG. 8 at a region II. The first component 3 is provided with a threaded hole h1, the second component 4 is provided with a first through hole h2, and the first through hole h2 is aligned with the threaded hole h1. An insulating material 8 is arranged between the first component 3 and the second component 4, and a material of the insulating material 8 includes, but is not limited to, mylar (mylar), rubber, and silica gel. The insulating material 8 is provided with a clearance hole h3, and the clearance hole h3 is aligned with and in communication with the first through hole h2 and the threaded hole h1.

The screw 7 includes a head and a shank, where the head is located on a side of the second component 4 that faces away from the first component 3, and the shank is accommodated within the first through hole h2, the clearance hole h3, and the threaded hole h1.

In this way, the insulating material 8 can help avoid direct contact between the second component 4 and the first component 3 at the position of the fixing member 7, thereby preventing corrosion.

In some embodiments, still referring to FIG. 12, a thickness of the insulating material 8 may be greater than or equal to 0.03 mm and less than or equal to 0.1 mm. When the thickness of the insulating material 8 is within this range, it can ensure the insulating performance, and effectively prevent contact between the first component 3 and the second component 4 at the fixed portion 7. In addition, it can prevent an increase in the stack thickness of the insulating material 8, which is beneficial to the thinning of the electronic device 10.

In some embodiments, still referring to FIG. 12, a boss 43 is provided between the first component 3 and the second component 4. The boss 43 is connected to one of the first component 3 and the second component 4, and the insulating material 8 is arranged between the other of the first component 3 and the second component 4 and the boss 43.

For example, referring to FIG. 12, the boss 43 may be connected to the second component 4, the boss 43 may be integrally formed with the component body 41 of the second component 4, or may be connected to the component body 41 through adhesive bonding, welding, and the like. This is not specifically limited in this application. The insulating material 8 is arranged between the first component 3 and the boss 43.

In another example, the boss 43 may be connected to the first component 3, the boss 43 may be integrally formed with the first component 3, or may be connected to the first component 3 through adhesive bonding, welding, and the like. This is not specifically limited in this application. The insulating material 8 is arranged between the second component 4 and the boss 43.

Based on any one of the foregoing embodiments, a second through hole h4 is provided within the boss 43, and the second through hole h4 is aligned with and in communication with the first through hole h2, the clearance hole h3, and the threaded hole h1. The shank of the screw 7 is accommodated within the first through hole h2, the second through hole h4, the clearance hole h3, and the threaded hole h1.

In this way, the boss 43 can help increase the height of the gap between the first component 3 and the second component 4, preventing another region of the first surface S1 from coming into contact with another region of the second surface S2, thereby reducing a corrosion risk. In addition, the boss 43 can help prevent the flatness of the first surface S1 and the second surface S2 from affecting the connection reliability between the first component 3 and the second component 4.

In some embodiments, referring to FIG. 12, a height of the boss 4 may be greater than or equal to 0.03 mm and less than or equal to 0.2 mm. When the height of the boss 4 is within this range, the height of the gap between the first component 3 and the second component 4 is moderate. The stack thickness of the first component 3 and the second component 4 is moderate, which is beneficial to the thinning of the electronic device 10. In addition, another region of the first surface S1 can be effectively prevented from coming into contact with another region of the second surface S2, thereby reducing the corrosion risk.

In the descriptions of this specification, the specified specific features, structures, materials, or characteristics may be combined in a proper manner in any one or more of the embodiments or examples.

In conclusion, it should be noted that, the foregoing embodiments are only used to describe the technical solutions of this application, but not intended to limit this application. Although this application has been described in detail with reference to the foregoing embodiments, it should be understood by a person skilled in the art that the technical solutions described in the foregoing embodiments can still be modified, or some or all of technical features can be replaced by equivalents. However, these modifications or substitutions do not cause the essence of corresponding technical solutions to depart from the spirit and scope of the technical solutions in the embodiments of this application.

## Claims

1. An electronic device, comprising:
a first component;
a hinge mechanism, wherein the hinge mechanism comprises a base, a first swing arm, and a second component, wherein the first swing arm is rotatably connected to the base, the second component is connected to an end of the first swing arm that is away from the base, the second component is fixed to the first component through a fixing member, an insulating material is provided between the first component and the second component at a position of the fixing member;
a conductive member, wherein the conductive member is arranged between the first component and the second component, and is in electrical conduction with the first component and the second component; and
a sealing ring, wherein the sealing ring is arranged between the first component and the second component, one end of the sealing ring in an axial direction faces the first component, the other end of the sealing ring faces the second component, and the conductive member is located within a region surrounded by the sealing ring, wherein
the fixing member is located on a side of the sealing ring that faces away from the conductive member.

2. The electronic device according to claim 1, wherein the conductive member is a conductive elastic piece.

3. The electronic device according to claim 2, wherein the conductive elastic piece comprises a fixed portion, an elastic arm portion, and a contact portion, wherein
the fixed portion is fixed to and in electrical conduction with the first component, and the contact portion is in contact with and in electrical conduction with the second component; and
a surface of the first component that faces the second component is a first surface, the elastic arm portion comprises a first end portion and a second end portion that are opposite to each other, and is inclined relative to the first surface in a direction from the first end portion to the second end portion, the first end portion is connected to and in electrical conduction with the fixed portion, and the second end portion is connected to and in electrical conduction with the contact portion.

4. The electronic device according to claim 3, wherein the fixed portion comprises a third end portion and a fourth end portion that are opposite to each other, and a direction from the third end portion to the fourth end portion is a first direction, wherein the first direction is parallel to the first surface; and
the first end portion is connected to and in electrical conduction with the fourth end portion, an orthographic projection of the first end portion on the first surface is a first projection, an orthographic projection of the second end portion on the first surface is a second projection, and a direction from the first projection to the second projection is a second direction, wherein the second direction is opposite to the first direction.

5. The electronic device according to claim 4, wherein the fixed portion and the elastic arm portion are arranged spaced apart along a third direction, wherein
the third direction is parallel to the first surface, and the third direction is perpendicular to the first direction.

6. The electronic device according to claim 5, wherein the conductive elastic piece further comprises a connecting portion, wherein
the connecting portion is located between the fourth end portion and the first end portion, and the connecting portion is connected to and in electrical conduction with both the fourth end portion and the first end portion; and
the connecting portion extends along the third direction from the fourth end portion to the first end portion.

7. The electronic device according to claim 6, wherein an orthographic projection of the elastic arm portion on the first surface is a third projection, and a length of the third projection in the first direction is less than a length of the fixed portion in the first direction.

8. The electronic device according to claim 7, wherein an edge of the second end portion that is away from the first end portion is a first edge, and a portion of the second end portion on which the first edge is located forms the contact portion.

9. The electronic device according to claim 8, wherein an edge of the second end portion that is away from the fixed portion is a third edge, and an arc transition edge or an inclined transition edge is connected between the third edge and the first edge.

10. The electronic device according to claim 7, wherein an edge of the second end portion that faces the fixed portion is a second edge, the second edge is a flange protruding toward the fixed portion, and an edge of the fixed portion that faces the elastic arm portion is provided with a first clearance notch; and
when the elastic arm portion bends toward the first component to be coplanar with the fixed portion, the first clearance notch is opposite to the second edge along the third direction.

11. The electronic device according to any one of claims 6 to 10, wherein the elastic arm portion further comprises an intermediate section, wherein the intermediate section is connected between the first end portion and the second end portion; and
an edge of the intermediate section that faces the fixed portion is a fourth edge, and an edge of the connecting portion that faces a gap between the intermediate section and the fixed portion is a fifth edge, wherein
the fourth edge is connected to the fifth edge, and the fourth edge is inclined to the fixed portion along a direction from the second end portion to the first end portion.

12. The electronic device according to claim 11, wherein an edge of the fixed portion that faces the elastic arm portion is provided with a second clearance notch, wherein
when the elastic arm portion bends toward the first component to be coplanar with the fixed portion, the second clearance notch is opposite to the fourth edge along the third direction.

13. The electronic device according to any one of claims 3 to 10, wherein the contact portion comprises a contact portion main body and a first contact layer, wherein
the second end portion is connected to and in electrical conduction with the contact portion main body; and the first contact layer is arranged on a surface of the contact portion main body, and an electrical conductivity of the first contact layer is higher than that of the contact portion main body; and
the first contact layer is in contact with the second component.

14. The electronic device according to claim 13, wherein a material of the first contact layer comprises at least one of gold, nickel, silver, or copper.

15. The electronic device according to any one of claims 3 to 10, wherein the surface of the first component that faces the second component is the first surface, and a surface of the second component that faces the first component is a second surface, wherein
the sealing ring is arranged between the first surface and the second surface.

16. The electronic device according to claim 15, wherein the first surface is provided with a first recessed groove, and at least the fixed portion in the conductive elastic piece is accommodated within the first recessed groove.

17. The electronic device according to any one of claims 3 to 10, wherein the second component comprises a component body and a contact member, wherein
the contact member is fixed to and in electrical conduction with the component body, and the contact portion is in contact with the contact member.

18. The electronic device according to claim 17, wherein a surface of the component body that faces the first component is provided with a second recessed groove, and the contact member is accommodated within the second recessed groove.

19. The electronic device according to claim 18, wherein the contact member comprises a contact member body and a second contact layer, wherein
the second contact layer is at least arranged on a surface of the contact member body that faces the first component, and an electrical conductivity of the second contact layer is higher than that of the contact member body; and
the second end portion is in contact with and in electrical conduction with the second contact layer.

20. The electronic device according to claim 1, wherein the fixing member is a screw.

21. The electronic device according to claim 20, wherein the first component is provided with a threaded hole, the second component is provided with a first through hole, and the first through hole is aligned with the threaded hole, wherein
the insulating material is provided with a clearance hole, and the clearance hole is aligned with and in communication with the first through hole and the threaded hole; and
the screw comprises a head and a shank, wherein the head is located on a side of the second component that faces away from the first component, and the shank is accommodated within the first through hole, the clearance hole, and the threaded hole.

22. The electronic device according to claim 21, wherein a boss is provided between the first component and the second component, the boss is connected to one of the first component and the second component, and the insulating material is arranged between the other of the first component and the second component and the boss; and
a second through hole is provided within the boss, the second through hole is aligned with and in communication with the first through hole, the clearance hole, and the threaded hole, and the shank is accommodated within the first through hole, the second through hole, the clearance hole, and the threaded hole.

23. The electronic device according to any one of claims 3 to 10, wherein a plurality of fixing members are provided, and the plurality of fixing members are connected between the edge of the second component and the first component; and
the conductive member and the sealing ring are located on a side of the plurality of fixed portions that faces a center of the second component.

24. The electronic device according to claim 1, wherein a material of at least one of the first component or the second component is magnesium alloy.

25. The electronic device according to claim 1, wherein the first component is a middle frame, and the second component is a connector.

26. A middle frame assembly, configured to be connected to a second component, wherein the middle frame assembly comprises:
a first component;
a hole, configured to accommodate a fixing member, wherein the fixing member is configured to fix the second component to the first component;
a conductive member, wherein when the second component is fixedly connected to the first component, the conductive member is located between the first component and the second component, and is configured to be in electrical conduction with the first component and the second component;
a sealing ring, wherein when the second component is fixedly connected to the first component, the sealing ring is located between the first component and the second component, one end of the sealing ring in an axial direction faces the first component, and the other end of the sealing ring faces the second component; the conductive member is located within a region surrounded by the sealing ring; and the hole is located on a side of the sealing ring that faces away from the conductive member; and
an insulating material, wherein when the second component is fixedly connected to the first component, the insulating material is located between the first component and the second component at a position of the fixing member.

27. The middle frame assembly according to claim 26, wherein the conductive member is a conductive elastic piece.

28. The middle frame assembly according to claim 27, wherein the conductive elastic piece comprises a fixed portion, an elastic arm portion, and a contact portion, wherein
the fixed portion is fixed to and in electrical conduction with the first component, and the contact portion is configured to be in contact with and in electrical conduction with the second component when the second component is fixedly connected to the first component; and
a surface of the first component that faces the conductive elastic piece is a first surface, the elastic arm portion comprises a first end portion and a second end portion that are opposite to each other, and is inclined relative to the first surface in a direction from the first end portion to the second end portion, the first end portion is connected to and in electrical conduction with the fixed portion, and the second end portion is connected to and in electrical conduction with the contact portion.

29. The middle frame assembly according to claim 28, wherein the fixed portion comprises a third end portion and a fourth end portion that are opposite to each other, and a direction from the third end portion to the fourth end portion is a first direction, wherein the first direction is parallel to the first surface; and
the first end portion is connected to and in electrical conduction with the fourth end portion, an orthographic projection of the first end portion on the first surface is a first projection, an orthographic projection of the second end portion on the first surface is a second projection, and a direction from the first projection to the second projection is a second direction, wherein the second direction is opposite to the first direction.

30. The middle frame assembly according to claim 29, wherein the fixed portion and the elastic arm portion are arranged spaced apart along a third direction, wherein
the third direction is parallel to the first surface, and the third direction is perpendicular to the first direction.

31. The middle frame assembly according to claim 30, wherein the conductive elastic piece further comprises a connecting portion, wherein
the connecting portion is located between the fourth end portion and the first end portion, and the connecting portion is connected to and in electrical conduction with both the fourth end portion and the first end portion; and
the connecting portion extends along the third direction from the fourth end portion to the first end portion.

32. The middle frame assembly according to claim 31, wherein an orthographic projection of the elastic arm portion on the first surface is a third projection, and a length of the third projection in the first direction is less than a length of the fixed portion in the first direction.

33. The middle frame assembly according to claim 32, wherein an edge of the second end portion that is away from the first end portion is a first edge, and a portion of the second end portion on which the first edge is located forms the contact portion.

34. The middle frame assembly according to claim 33, wherein
an edge of the second end portion that is away from the fixed portion is a third edge, and an arc transition edge or an inclined transition edge is connected between the third edge and the first edge.

35. The middle frame assembly according to claim 32, wherein an edge of the second end portion that faces the fixed portion is a second edge, the second edge is a flange protruding toward the fixed portion, and an edge of the fixed portion that faces the elastic arm portion is provided with a first clearance notch; and
when the elastic arm portion bends toward the first component to be coplanar with the fixed portion, the first clearance notch is opposite to the second edge along the third direction.

36. The middle frame assembly according to any one of claims 31 to 35, wherein the elastic arm portion further comprises an intermediate section, wherein the intermediate section is connected between the first end portion and the second end portion; and
an edge of the intermediate section that faces the fixed portion is a fourth edge, and an edge of the connecting portion that faces a gap between the intermediate section and the fixed portion is a fifth edge, wherein
the fourth edge is connected to the fifth edge, and the fourth edge is inclined to the fixed portion along a direction from the second end portion to the first end portion.

37. The middle frame assembly according to claim 36, wherein an edge of the fixed portion that faces the elastic arm portion is provided with a second clearance notch, wherein
when the elastic arm portion bends toward the first component to be coplanar with the fixed portion, the second clearance notch is opposite to the fourth edge along the third direction.

38. The middle frame assembly according to any one of claims 28 to 35, wherein the contact portion comprises a contact portion main body and a first contact layer, wherein
the second end portion is connected to and in electrical conduction with the contact portion main body; and the first contact layer is located on a surface of the contact portion main body, and an electrical conductivity of the first contact layer is higher than that of the contact portion main body; and
the first contact layer is configured to be in contact with the second component when the second component is fixedly connected to the first component.

39. The middle frame assembly according to claim 38, wherein a material of the first contact layer comprises at least one of gold, nickel, silver, or copper.

40. The middle frame assembly according to any one of claims 26 to 39, wherein when the second component is fixedly connected to the first component, the surface of the first component that faces the second component is the first surface, and a surface of the second component that faces the first component is a second surface; and
the sealing ring is located between the first surface and the second surface.

41. The middle frame assembly according to claim 28 or 40, wherein the first surface is provided with a first recessed groove, and at least the fixed portion in the conductive elastic piece is accommodated within the first recessed groove.

42. The middle frame assembly according to any one of claims 26 to 41, wherein the fixing member is a screw.

43. The middle frame assembly according to claim 42, wherein the hole is a threaded hole, and the threaded hole is configured to be aligned with a first through hole of the second component when the second component is fixedly connected to the first component;
the insulating material is provided with a clearance hole, and the clearance hole is aligned with and in communication with the threaded hole; and
the screw comprises a head and a shank, wherein the head is located on a side of the second component that faces away from the first component, and the shank is accommodated within the first through hole, the clearance hole, and the threaded hole when the second component is fixedly connected to the first component.

44. The middle frame assembly according to claim 43, wherein the middle frame assembly further comprises a boss, wherein the boss is connected to the first component, a second through hole is provided within the boss, and the second through hole is aligned with and in communication with the clearance hole and the threaded hole; and
when the second component is fixedly connected to the first component, the boss is located between the first component and the second component, the insulating material is located between the second component and the boss, and the shank is accommodated within the first through hole, the second through hole, the clearance hole, and the threaded hole.

45. The middle frame assembly according to any one of claims 26 to 44, wherein a plurality of fixing members are provided, and the plurality of fixing members are configured to be connected between the edge of the second component and the first component; and
when the second component is fixedly connected to the first component, the conductive member and the sealing ring are located on a side of the plurality of fixed portions that faces a center of the second component.

46. The middle frame assembly according to any one of claims 26 to 45, wherein the middle frame assembly is configured to be connected to the second component; and
a material of at least one of the first component or the second component is magnesium alloy.

47. The middle frame assembly according to any one of claims 26 to 46, wherein the middle frame assembly is configured to be connected to the second component; and
the first component is a middle frame, and the second component is a connector on a hinge mechanism, wherein
the hinge mechanism comprises a base, a swing arm, and the connector, wherein the swing arm is rotatably connected to the base, the connector is connected to an end of the swing arm that is away from the base, and the connector is configured to be fixed to the middle frame through the fixing member.
